Europäisches Patentamt

European Patent Office

Office européen des brevets

(19)

(11) Numéro de publication : **0 058 113
B1**

# (12) FASCICULE DE BREVET EUROPÉEN

(45) Date de publication du fascicule du brevet :
26.06.85

(21) Numéro de dépôt : 82400169.7

(22) Date de dépôt : 29.01.82

(51) Int. Cl.⁴ : **H 03 H 19/00, H 04 L 27/14**

(54) **Filtre à capacités commutées et modem comportant de tels filtres.**

(30) Priorité : 10.02.81 FR 8102596

(43) Date de publication de la demande :
18.08.82 Bulletin 82/33

(45) Mention de la délivrance du brevet :
26.06.85 Bulletin 85/26

(84) Etats contractants désignés :
DE FR GB IT NL

(56) Documents cités :
L.R. RABINER et B. GOLD "Theory and application of
digital signal processing" 1975 PRENTICE-HALL INC.
Englewood Cliffs NEW JERSEY (US) chapitre 2,
pages 9-74 et chapitre 4, pages 205-294
ELECTRONICS LETTERS, volume 16, no. 20, 25 septembre 1980 HITCHIN-HERTS (GB) T. INOUE et al.
"Switched-capacitor immittance convertors using a
single operational amplifier", pages 770-771
IEEE JOURNAL OF SOLID-STATE CIRCUITS, volume
SC-12, no. 6, décembre 1977 NEW YORK (US) J.T.
CAVES et al. "Sampled analog filtering using switched capacitors as resistor equivalents" pages 592-
593
IEEE JOURNAL OF SOLID-STATE CIRCUITS, volume
SC-12, no. 6, décembre 1977 NEW YORK (US) B.J.
HOSTICKA et al.: "MOS sampled data recursive
filters using switched capacitor integrators" pages
600-608

(73) Titulaire : THOMSON-CSF
173, Boulevard Haussmann
F-75379 Paris Cedex 08 (FR)

(72) Inventeur : Picquendar, Jean-Edgar
THOMSON-CSF SCPI 173, bld Haussmann
F-75360 Paris Cedex 08 (FR)

(74) Mandataire : Mayeux, Michèle et al
THOMSON-CSF SCPI 173, Bld Haussmann
F-75379 Paris Cedex 08 (FR)

## Description

La présente invention concerne les filtres à capacités commutées. Elle se rapporte également aux modems comportant de tels filtres.

Les filtres à capacités commutées sont maintenant bien connus, notamment par deux articles de la revue américaine « IEEE Journal of Solid-States Circuits », volume SC-12, n° 6, décembre 1977, pages 592 à 608.

Les filtres à capacités commutées sont généralement présentés comme des filtres, de mêmes caractéristiques que les filtres actifs classiques constitués d'un amplificateur associé à un réseau de résistances et de capacités, mais qui s'en distinguent par le fait qu'ils utilisent des capacités MOS commutées à la place des résistances et qu'ils peuvent donc être totalement intégrés tout en conservant une très grande précision.

Cette façon de présenter les filtres à capacités commutées comme la transposition des structures existantes des filtres actifs R.C. fait qu'il est admis que les filtres à capacités commutées, comme les filtres actifs, ne permettent d'obtenir que des fonctions de transfert présentant un nombre de pôles supérieur ou égal à celui du nombre de zéros.

Cette limitation est gênante dans de nombreuses applications, et notamment pour réaliser certains types de démodulateurs de modems, comme on le verra par la suite.

La présente invention permet d'obtenir le schéma électrique de filtres à capacité commutées présentant des fonctions de transfert dont le nombre de pôles et le nombre de zéros sont totalement indépendants.

La présente invention concerne également l'application de ces filtres à la réalisation de démodulateurs de modems ; ces démodulateurs nécessitent en effet des filtres dont la fonction de transfert présente un nombre de zéros supérieur au nombre de pôles.

La présente invention permet d'obtenir, de la façon exposée dans ce qui suit, la structure de filtres à capacités commutées dont la fonction de transfert en z, T(z), s'écrit sous la forme du rapport de deux polynômes en $z^{-1}$, avec éventuellement un facteur multiplicatif $z^{-k}$, $k \geqslant 0$

$$T(z) = z^{-k} \cdot \frac{p(z^{-1})}{q(z^{-1})}$$

où

$$P(z^{-1}) = p_0 + p_1 z^{-1} + \cdots + p_m z^{-m}$$

$$Q(z^{-1}) = q_0 + q_1 z^{-1} + \cdots + q_n z^{-n}$$

avec $p_0 \neq 0$ et $q_0 \neq 0$

Les filtres selon l'invention sont, de manière inattendue, des filtres à capacités commutées ayant une telle fonction de transfert avec m strictement supérieur à n, ce qui n'a jamais été réalisé ni même considéré comme possible jusqu'à maintenant, faute de procédé pour synthétiser de tels filtres.

Ces filtres comprennent seulement m + k amplificateurs opérationnels et éventuellement des inverseurs pour réaliser certaines fonctions de transfert.

Parmi ces amplificateurs, m sont connectés de la manière suivante : il est prévu entre la sortie de chaque amplificateur et l'entrée négative d'au moins un des m amplificateurs (le même et/ou un autre ou plusieurs autres), un élément de circuit ou plusieurs éléments de circuits en parallèle, chaque élément comprenant une seule capacité, commutée ou non, selon des schémas simples qui seront explicités ci-après.

Pour obtenir la structure de ces filtres, on procède de la manière suivante :

On écrit l'égalité entre la fonction de transfert T'(z) et le rapport des déterminants de deux matrices carrées, A et B, de p lignes et p colonnes, où p représente la valeur supérieure de m et de n, chacun des termes de ces matrices étant un polynoûme du 1er degré en $z^{-1}$ de la forme $a_{ij} \cdot z^{-1} + b_{ij}$, et les deux matrices ne différant que par les termes de leur dernière colonne :

$$T(z) = \frac{P(z^{-1})}{Q(z^{-1})} = \frac{\text{dét } A}{\text{dét } B};$$

on détermine à partir de cette égalité les coefficients $a_{ij}$ et $b_{ij}$ de façon que les polynômes $a_{ij} \cdot z^{-1} + b_{ij}$ puissent être obtenus par la mise en parallèle de dispositifs à capacités commutées classiques et de capacités ;

on écrit les p équations découlant de la relation suivante :

(Voir formule p. 3).

2

$$\text{matrice B.} \quad \begin{vmatrix} V_1 \\ V_2 \\ \cdot \\ \cdot \\ \cdot \\ V_p \end{vmatrix} - \begin{vmatrix} a_{1p}.z^{-1} + b_{1p} \\ a_{2p}.z^{-1} + b_{2p} \\ \cdot \qquad\qquad \cdot \\ \cdot \qquad\qquad \cdot \\ \cdot \qquad\qquad \cdot \\ a_{pp}.z^{-1} + b_{pp} \end{vmatrix} \cdot V_e = 0$$

où $V_e$ représente la tension d'entrée du filtre, où $V_1$, $V_2$... $V_p$ représentent les tensions de sortie des p amplificateurs différentiels que comporte le filtre, et où les polynômes affectant $V_e$ proviennent de la dernière colonne de la matrice A ;

on établit le schéma électrique du filtre à partir de ces équations, chaque équation correspondant à un amplificateur différentiel ayant son entrée positive à la masse et qui fournit une tension de sortie $V_i$, le coefficient affectant dans cette équation $- V_e$ correspondant à des dispositifs à capacités commutées classiques en parallèle avec des capacités, qui réalisent ce coefficient et qui sont intercalés entre l'entrée négative de l'amplificateur et la tension d'entrée $V_e$, les coefficients affectant les autres tensions $V_1$... $V_p$, exceptée $V_i$, correspondant à des dispositifs à capacités commutées classiques en parallèle avec des capacités qui réalisent ces coefficients et qui sont placés entre l'entrée négative de l'amplificateur fournissant $V_i$ et la sortie des amplificateurs fournissant les tensions $V_1$... $V_p$, exceptée $V_i$, enfin le coefficient affectant la tension $V_i$ correspondant à au moins une capacité placée entre la sortie de l'amplificateur fournissant la tension de sortie $V_i$ et l'entrée négative de cet amplificateur, avec éventuellement en parallèle sur cette capacité des dispositifs à capacités commutées classiques et d'autres capacités.

La sortie du filtre réalisant la fonction de transfert $P(z^{-1})/Q(z^{-1})$ est prise à la sortie du $p^e$ amplificateur. Le retard éventuel $z^{-k}$ est réalisé séparément.

D'autres objets, caractéristiques et résultats de l'invention ressortiront de la description suivante, donnée à titre d'exemple non limitatif et illustrée par les figures annexées qui représentent :

La figure 1, le schéma d'un filtre à capacités commutées selon l'invention ;

Les figures 2a, 2b, 2c et 2d, des éléments de circuit à capacités commutées ou non destinés à être connectés en amont de l'entrée négative de chaque amplificateur ;

La figure 3, un schéma de filtre dont la fonction de transfert est un polynôme du second degré en $z^{-1}$ ;

La figure 4, le schéma d'un démodulateur de modem F.S.K. utilisant des filtres à capacités commutées selon l'invention ;

La figure 5, la courbe de réponse de comparateurs utilisés dans ces démodulateurs.

Sur les différentes figures, les mêmes repères désignent les mêmes éléments, mais pour des raisons de clarté, les cotes et proportions des divers éléments ne sont pas respectées.

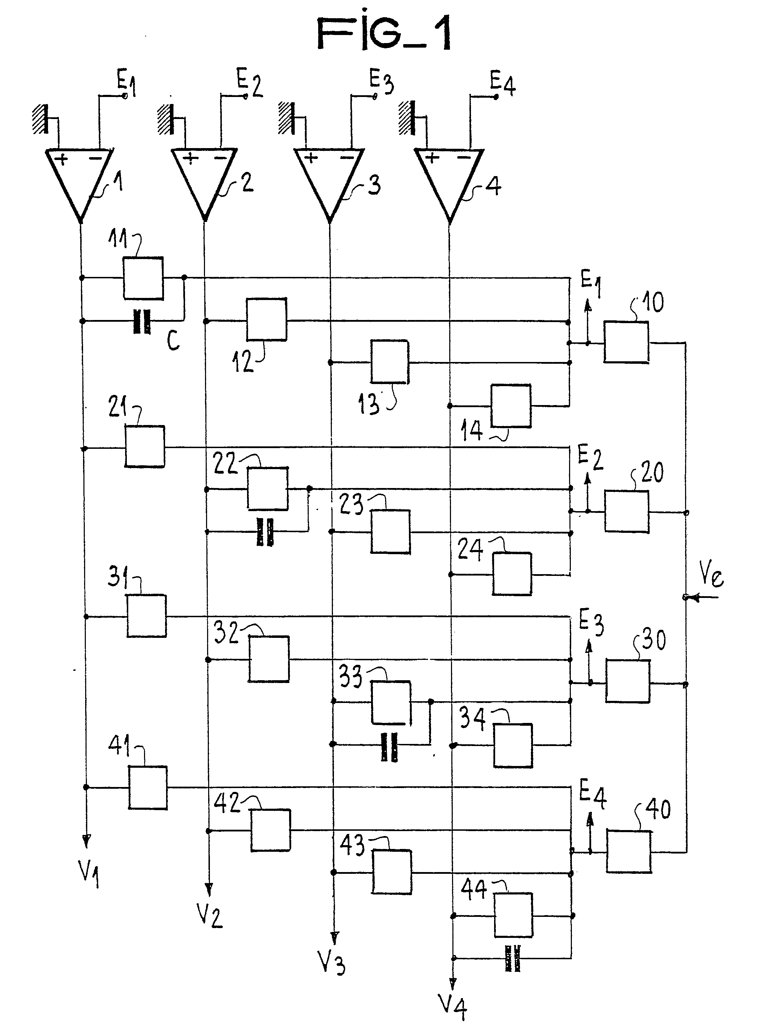

La figure 1 représente le schéma d'un filtre à capacités commutées selon l'invention. L'invention permet donc d'obtenir la structure d'un filtre à capacités commutées dont la fonction de transfert en z, $T(z)$, s'écrit sous la forme du rapport de deux polynômes en $z^{-1}$, $P(z^{-1})$ et $Q(z^{-1})$. Le procédé proposé ici permet de réaliser cette fonction de transfert quels que soient les degrés m et n de ces polynômes, mais on s'intéressera ci-après qu'aux filtres à capacités commutées nouveaux pour lesquels m est strictement supérieur à n.

Dans ce qui suit, on prendra, à titre d'exemple uniquement, m = 4 et n = 2. On supposera que k = 0 et qu'il n'y a donc pas de facteur multiplicatif $z^{-k}$.

On peut donc écrire la fonction de transfert $T(z)$ de la façon suivante :

$$T(z) = \frac{P(z^{-1})}{Q(z^{-1})} = \frac{p_0 + p_1.z^{-1} + p_2.z^{-2} + p_3.z^{-3} + p_4.z^{-4}}{q_0 + q_1.z^{-1} + q_2.z^{-2}}$$

tous les coefficients $p_0$... $p_4$ et $q_0$ ... $q_2$ étant connus, avec $p_0 \neq 0$ et $q_0 \neq 0$.

L'obtention du schéma du filtre à capacités commutées ayant $T(z)$ pour fonction de transfert en z se fait en quatre étapes.

Dans une première étape, on écrit l'égalité entre la fonction de transfert $T(z)$ et le rapport des déterminants de deux matrices carrées, A et B, de p lignes et p colonnes, où p représente la valeur supérieure de m et de n. Chacun des termes de ces matrices est un polynôme du $1^{er}$ degré en $z^{-1}$ de la forme : $a_{ij} \cdot z^{-1} + b_{ij}$. Les deux matrices A et B ne diffèrent l'une de l'autre que par les termes de leur dernière colonne. Dans le cas où m = 4 et n = 2, on a alors p = 4 et on peut écrire les deux matrices A et B de la façon suivante :

$$A = \begin{vmatrix} a_{11}.z^{-1} + b_{11} & a_{12}.z^{-1} + b_{12} & a_{13}.z^{-1} + b_{13} & a_{14}.z^{-1} + b_{14} \\ a_{21}.z^{-1} + b_{21} & a_{22}.z^{-1} + b_{22} & a_{23}.z^{-1} + b_{23} & a_{24}.z^{-1} + b_{24} \\ a_{31}.z^{-1} + b_{31} & a_{32}.z^{-1} + b_{32} & a_{33}.z^{-1} + b_{33} & a_{34}.z^{-1} + b_{34} \\ a_{41}.z^{-1} + b_{41} & a_{42}.z^{-1} + b_{42} & a_{43}.z^{-1} + b_{43} & a_{44}.z^{-1} + b_{44} \end{vmatrix}$$

$$B = \begin{vmatrix} a_{11}.z^{-1} + b_{11} & a_{12}.z^{-1} + b_{12} & a_{13}.z^{-1} + b_{13} & a_{15}.z^{-1} + b_{15} \\ a_{21}.z^{-1} + b_{21} & a_{22}.z^{-1} + b_{22} & a_{23}.z^{-1} + b_{23} & a_{25}.z^{-1} + b_{25} \\ a_{31}.z^{-1} + b_{31} & a_{32}.z^{-1} + b_{32} & a_{33}.z^{-1} + b_{33} & a_{35}.z^{-1} + b_{35} \\ a_{41}.z^{-1} + b_{41} & a_{42}.z^{-1} + b_{42} & a_{43}.z^{-1} + b_{43} & a_{45}.z^{-1} + b_{45} \end{vmatrix}$$

tous les coefficients $a_{ij}$, $b_{ij}$, $i = 1$ à 4 et $j = 1$ à 5 étant inconnus.

Au cours de la première étape, on écrit donc l'égalité suivante :

$$T(z) = \frac{\text{dét } A}{\text{dét } B} . \tag{I}$$

Au cours de la deuxième étape, on détermine à partir de l'égalité (I) tous les coefficients $a_{ij}$ et $b_{ij}$ des deux matrices A et B.

Dans le cas pris en exemple, on dispose de 8 données qui sont les coefficients $p_0$ à $p_4$ et $q_0$ à $q_2$ de la fonction de transfert T(z) et on veut déterminer les valeurs de 40 coefficients qui sont les $a_{ij}$ et les $b_{ij}$ des matrices A et B.

Il est donc nécessaire d'imposer les valeurs de certains des coefficients $a_{ij}$ et $b_{ij}$. De plus, dans le cas où le numérateur et le dénominateur de la fonction de transfert ne sont pas du même ordre, certains des coefficients $a_{ij}$ et $b_{ij}$ doivent être nuls.

Enfin, au cours de la détermination des coefficients $a_{ij}$ et $b_{ij}$ des deux matrices A et B, il faut choisir des coefficients $a_{ij}$ et $b_{ij}$ tels que les polynômes $a_{ij} \cdot z^{-1} + b_{ij}$, des matrices puissent être réalisés par des dispositifs à capacités commutées classiques en parallèle avec des capacités.

Il est possible d'effectuer des transformations sur les matrices A et B pour que les termes de ces matrices puissent être réalisés par des dispositifs à capacités commutées classiques en parallèle avec des capacités. On peut faire toutes les transformations habituelles aux systèmes de n équations linéaires à n inconnues.

Ainsi, on ne change pas la fonction de transfert T(z), si l'on remplace une ligne de la matrice A ou de la matrice B par une combinaison linéaire des lignes de la matrice considérée, de même on ne change pas la fonction de transfert T(z), si l'on remplace une colonne de la matrice A ou de la matrice B par une combinaison linéaire des colonnes de la matrice considérée, exceptée la dernière colonne de la matrice A.

On peut aussi sans changer la fonction de transfert T(z) multiplier par une constante K une colonne des matrices A et B (on divise alors par K la tension de sortie de l'amplificateur opérationnel servant à réaliser le filtre et correspondant à cette colonne — s'il s'agit de la 1re colonne ce sera l'amplificateur $A_1$, comme on le verra par la suite, s'il s'agit de la 2e colonne ce sera l'amplificateur $A_2$...).

On peut aussi sans changer la fonction de transfert T(z) multiplier par une constante K une ligne des matrices A et B sans changer les tensions de sortie des divers amplificateurs.

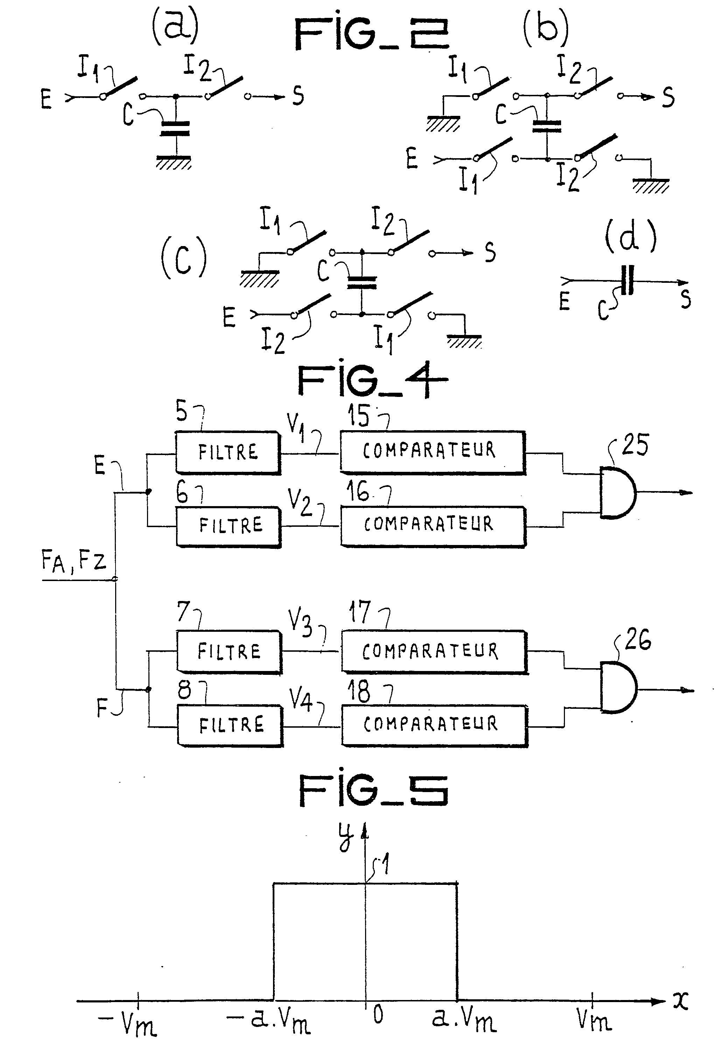

Les figures 2a, 2b, 2c et 2d représentent un élément de circuit servant à réaliser les filtres selon l'invention. Les éléments de circuit des figures 2a, 2b et 2c sont des dispositifs à capacités commutées ; celui de la figure 2d est une capacité non commutée. Les dispositifs des figures 2a, 2b et 2c comportent chacun une capacité C et un ou plusieurs interrupteurs appelées $I_1$ et $I_2$. Les interrupteurs $I_1$ et $I_2$, qui sont bien sûr des interrupteurs électroniques généralement constitués de transistors MOS, sont périodiquement ouverts et fermés par application de deux signaux d'horloge, $\Phi_1$, pour les interrupteurs $I_1$ et $\Phi_2$, pour les interrupteurs $I_2$. Les signaux d'horloge $\Phi_1$ et $\Phi_2$ sont des signaux en créneaux, périodiques, qui sont en opposition de phase et qui ne se recouvrent pas au niveau haut qui rend conducteurs les transistors MOS. La période T des signaux d'horloge $\Phi_1$ et $\Phi_2$ est telle que $z = e^{+j\omega T}$ avec $\omega = 2\pi f$.

La figure 2a représente un dispositif à capacités commutées constitué de deux interrupteurs $I_1$ et $I_2$ en série entre l'entrée E et la sortie S et d'une capacité C entre le point commun à ces interrupteurs et la masse.

Ce dispositif, placé en amont de l'entrée négative d'un amplificateur opérationnel bouclé par une capacité non commutée $C_0$ placée entre son entrée et sa sortie, permet de réaliser une fonction de transfert égale à

$$-\frac{C}{C_0} - \frac{z^{-1}}{1 - z^{-1}} .$$

Par extension, et pour simplifier les opérations de détermination des éléments du filtre, on dira que le dispositif de la figure 2a réalise une fonction de transfert $C z^{-1}$ : il applique à l'entrée de l'amplificateur opérationnel une charge $C z^{-1}$ ; on dira aussi que la capacité de bouclage $C_0$ réalise entre la sortie et l'entrée de l'amplificateur une fonction de transfert $C_0 (1 - z^{-1})$, et, plus généralement, que toute capacité de liaison directe C placée en amont de l'entrée négative de l'amplificateur bouclé par la capacité $C_0$, réalisera une fonction de transfert $C (1 - z^{-1})$.

La figure 2b représente un dispositif à capacités commutées constitué de deux interrupteurs $I_1$ et $I_2$

4

en série entre l'entrée E et la masse, et de deux interrupteurs $I_1$ et $I_2$ en série entre la masse et la sortie S, avec une capacité C, qui relie les points communs aux deux séries d'interrupteurs.

Ce dispositif, placé en amont de l'entrée négative d'un amplificateur opérationnel bouclé par une capacité non commutée $C_0$ placée entre son entrée et sa sortie, permet de réaliser une fonction de transfert égale à

$$- \frac{C}{C_0} \cdot \frac{(-z^{-1})}{1 - z^{-1}} \cdot$$

Par extension, et pour simplifier les opérations de détermination des éléments du filtre, on dira que le dispositif de la figure 2b réalise une fonction de transfert $C\, z^{-1}$, et que la capacité de bouclage $C_0$ réalise encore une fonction de transfert $C_0\, (1 - z^{-1})$.

La figure 2c ne diffère de la figure 2b que par le fait que dans la série de deux interrupteurs reliés entre l'entrée E et de la masse, on trouve l'interrupteur $I_2$ avant l'interrupteur $I_1$.

Ce dispositif, placé en amont de l'entrée négative d'un amplificateur opérationnel bouclé par une capacité $C_0$ non commutée, permet de réaliser une fonction de transfert

$$- \frac{C}{C_0} \cdot \frac{1}{(1 - z^{-1})} \cdot$$

Par extension, on dira que le dispositif de la figure 2c a une fonction de transfert $C \times 1$, et que la capacité de bouclage $C_0$ réalise encore une fonction de transfert $C_0\, (1 - z^{-1})$.

Enfin, la figure 2d montre le quatrième type d'élément de circuit, et, cette fois, il s'agit simplement d'une capacité non commutée C.

Cette capacité de liaison directe C, placée en amont d'un amplificateur opérationnel bouclé par une capacité non commutée $C_o$, permettrait de réaliser une fonction de transfert

$$- \frac{C}{C_0} \cdot \frac{1 - z^{-1}}{1 - z^{-1}} \cdot$$

Par extension, on dira que la capacité de liaison directe C a une fonction de transfert $C(1 - z^{-1})$, ce qui est cohérent avec ce qu'on a dit des capacités de liaison directe à propos de la figure 2a, et ce qu'on a dit des capacités de bouclage $C_0$ (qui sont des capacités de liaison directe ramenant une tension de sortie de l'amplificateur sur son entrée négative) à propos des figures 2a, 2b, 2c.

On va donc utiliser les éléments de circuit très simples des figures 2a, 2b, 2c, 2d, réalisant les fonctions de transfert $Cz^{-1}$, $-Cz^{-1}$, $C(1 - z^{-1})$ pour bâtir les filtres selon l'invention.

D'après la convention d'écriture adoptée pour ces fonctions de transfert simples, l'addition de deux fonctions de transfert simples correspondra à la mise en parallèle de deux éléments de circuit correspondant à ces fonctions.

Les coefficients $a_{ij}$ et $b_{ij}$ des matrices A et B étant déterminés, au cours de la troisième étape, on écrit les p équations, 4 dans l'exemple choisi, qui découlent de la relation suivante :

$$\text{matrice B.} \begin{vmatrix} V_1 \\ V_2 \\ V_3 \\ V_4 \end{vmatrix} - \begin{vmatrix} a_{14}.z^{-1} + b_{14} \\ a_{24}.z^{-1} + b_{24} \\ a_{34}.z^{-1} + b_{34} \\ a_{44}.z^{-1} + b_{14} \end{vmatrix} \cdot V_e = 0 \, . \tag{II}$$

Dans cette relation, la tension $V_e$ représente la tension d'entrée du filtre, les tensions $V_1$, $V_2$, $V_3$, $V_4$ représentent les tensions de sortie des 4 amplificateurs différentiels que comporte le filtre et les polynômes affectant $V_e$ proviennent de la dernière colonne de la matrice A.

On donne à titre d'exemple l'une de ces quatre équations qui s'écrit :

$$(a_{11}.z^{-1} + b_{11}).V_1 + (a_{12}.z^{-1} + b_{12}).V_2 + (a_{13}.z^{-1} + b_{13}) \times$$
$$\times V_3 + (a_{15}.z^{-1} + b_{15}).V_4 - (a_{14}.z^{-1} + b_{14}).V_e = 0 \, . \tag{III} \, .$$

Les trois autres équations ne diffèrent de celle-ci que parce qu'elles utilisent les coefficients $a_{ij}$ et $b_{ij}$ pour lesquels i = 2, 3 ou 4 pour j = 1 à 5 alors que celle-ci utilise les coefficients $a_{ij}$ et $b_{ij}$ pour lesquels i = 1 et j = 1 à 5.

Au cours de la quatrième étape, on établit le schéma électrique du filtre en utilisant les équations découlant de la relation II.

Chacune de ces équations correspond à un amplificateur différentiel. Sur la figure 1, on a représenté, le schéma du filtre correspondant à l'exemple choisi, avec m = 4 et n = 2. La relation II fournit dans ce cas 4 équations et on est donc conduit à utiliser 4 amplificateurs différentiels repérés de 1 à 4 sur la figure 1.

Chacun de ces amplificateurs 1, 2, 3, 4 a son entrée positive à la masse et fournit une tension de sortie $V_1$, $V_2$, $V_3$, $V_4$.

Les entrées négatives des amplificateurs 1, 2, 3, et 4 sont repérées par les références $E_1$, $E_2$, $E_3$ et $E_4$.

On va montrer dans ce qui suit comment on utilise l'équation III pour réaliser le schéma du filtre.

L'équation III est réalisée à partir de l'amplificateur différentiel 1 qui fournit la tension de sortie $V_1$. Le coefficient $(a_{14} \cdot z^{-1} + b_{14})$ qui affecte dans cette équation $-V_e$ est réalisé en utilisant des éléments de circuit pris parmi les figures 2a à 2d (un ou plusieurs éléments en parallèle). Ces éléments sont repérés par la référence 10 et intercalés entre l'entrée négative $E_1$ de l'amplificateur 1 et la tension d'entrée du filtre $V_e$. Le coefficient $(a_{12} \cdot z^{-1} + b_{12})$ qui affecte $V_2$ est réalisé en plaçant entre l'entrée négative $E_1$ de l'amplificateur différentiel 1 et la sortie de l'amplificateur 2 fournissant $V_2$ des éléments de circuit pris parmi les figures 2a à 2d (un ou plusieurs en parallèle, repérés par la référence 12). De même, les coefficients, $(a_{13} \cdot z^{-1} + b_{13})$ et $(a_{15} \cdot z^{-1} + b_{15})$ qui affectent, $V_3$ et $V_4$ sont réalisés en plaçant entre l'entrée négative $E_1$ de l'amplificateur différentiel 1 et les sorties des amplificateurs 3 et 4, qui fournissent les tensions $V_3$ et $V_4$ un ou plusieurs éléments de circuits désignés par 13 et 14, pris parmi les figures 2a à 2d.

Le coefficient $(a_{11} \cdot z^{-1} + b_{11})$ qui affecte $V_1$ est obtenu par au moins une capacité C placée entre la sortie de l'amplificateur 1 et son entrée négative $E_1$, avec éventuellement en parallèle sur cette capacité un ou plusieurs éléments de circuit désignés par la référence 11 et pris parmi les figures 2a à 2d.

On constate en examinant la figure 1 que l'équation III traduit le fait que l'entrée négative de l'amplificateur différentiel 1 ne reçoit aucun courant.

A partir des 3 autres équations découlant de la relation II, on établit le reste du schéma électrique qui est constitué de trois amplificateurs différentiels 2, 3, 4 de dispositifs à capacités commutées et de capacités repérés par les références 20 à 24, 30 à 34 et 40 à 44, et de capacités C.

La tension de sortie du filtre est prise à la sortie de l'amplificateur 4, car on peut vérifier que

$$V_4 = V_e \times \frac{\text{dét A}}{\text{dét B}} = V_e \cdot T(z) \ .$$

On constate donc qu'il est possible d'obtenir des filtres à capacités commutées dont la fonction de transfert en z présente un nombre de zéros et un nombre de pôles totalement indépendants. Le nombre le plus élevé, le nombre de zéros pour les nouveaux filtres à capacités commutées selon l'invention, est celui qui détermine essentiellement le nombre d'amplificateurs opérationnels que comporte le filtre. A ce nombre, il faut parfois rajouter des amplificateurs pour réaliser le retard $z^{-k}$ et pour réaliser des inversions de signal nécessaires en fonction du signe de certains coefficients.

La description a été faite pour p = 4 mais peut se généraliser à p quelconque.

Pour mieux faire comprendre le procédé de synthèse de filtres qui vient d'être exposé, on va prendre un exemple numérique simple correspondant à la synthèse d'un filtre à réponse impulsionnelle finie (FIR), c'est-à-dire un filtre non récursif ayant une fonction de transfert qui est un polynôme $P(z^{-1})$ avec $Q(z^{-1}) = 1$

$$T(z) = P(z^{-1})$$

Ces filtres ont toujours été considérés comme irréalisables avec des capacités commutées ; ils sont en tout cas irréalisables avec des inductances et des capacités.

On veut réaliser par exemple :

$$T(z) = - (1 + p1z^{-1} + p2z^{-2})$$

On peut écrire les deux matrices A et B suivantes :

$$A = \begin{vmatrix} 1 - z^{-1} & -2 - p_1 + (1 - p_2)\, z^{-1} \\ -z^{-1} & -(1 - z^{-1}) \end{vmatrix} \qquad B = \begin{vmatrix} 1 - z^{-1} & 2 - z^{-1} \\ -z^{-1} & 1 - z^{-1} \end{vmatrix} .$$

Pour définir ces matrices, on a choisi arbitrairement trois termes qui sont $1 - z^{-1}$, $-z^{-1}$ ou $-(1 - z^{-1})$ et on a calculé le quatrième terme de chaque matrice pour réaliser dét $A = T(z) = -(1 + p1z^{-1} + p2z^2)$ et dét B = 1. Cependant, on aurait pu choisir d'autres valeurs pour les trois premiers termes.

On obtient donc bien

$$T(z) = \frac{\text{dét A}}{\text{dét B}} \ .$$

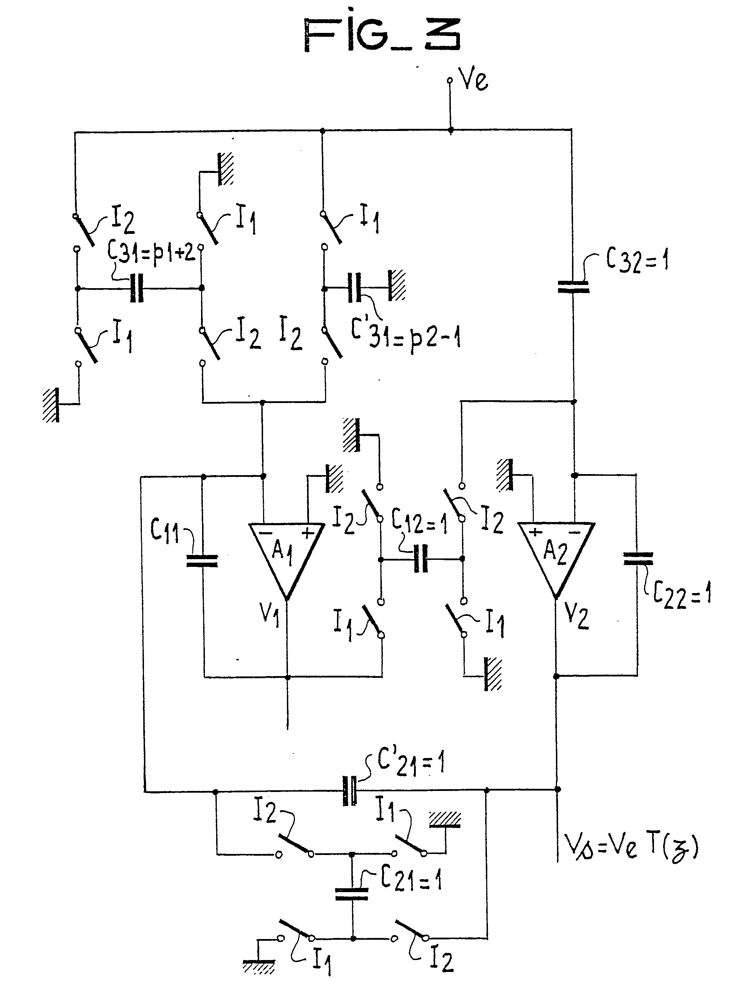

On détermine alors un schéma (Fig. 3) à deux amplificateurs opérationnels A1 et A2 (tensions de sortie V1 et V2), la tension d'entrée du filtre étant Ve et la tension de sortie du filtre étant :

$$V2 = Ve \times \frac{\text{dét A}}{\text{dét B}}.$$

En décomposant l'équation matricielle suivante :

$$(B). \begin{vmatrix} V1 \\ V2 \end{vmatrix} - \begin{vmatrix} -2 - p1 + (1 - p2) z^{-1} \\ -1 - z^{-1} \end{vmatrix} \cdot Ve = 0,$$

On obtient les deux équations :

$$(1 - z^{-1}) V1 + (2 - z^{-1}) V2 + (p1 + 2) Ve + (p2 - 1) z^{-1} Ve = 0,$$

$$- z^{-1} V1 + (1 - z^{-1}) V2 + (1 - z^{-1}) Ve = 0.$$

Ces deux équations permettent de représenter l'arrivée des connexions à l'entrée négative de chacun des amplificateurs, A1 et A2 respectivement.

Pour le premier, le terme $(1 - z^{-1})$ V1 correspond à la tension de sortie V1 du premier amplificateur, ramenée à son entrée négative par une capacité C11 non commutée de valeur unitaire (élément de circuit de la figure 2d en parallèle entre la sortie et l'entrée de l'amplificateur A1, avec C11 = 1). Le terme $2 - Z^{-1}$ qui affecte V2 peut s'écrire $1 + (1 - z^{-1})$, ce qui représente l'addition de deux transferts de charge de la sortie de l'amplificateur A2 vers l'entrée négative de A1 : l'un s'effectue à travers une capacité commuté C21 de valeur unitaire, selon le schéma de la figure 2c, donnant le coefficient 1, l'autre à travers une capacité C'21, non commutée (Fig. 2d), de valeur unitaire, donnant le coefficient $(1 - z^{-1})$. Ces deux éléments de circuit sont placés en parallèle l'un avec l'autre, entre la sortie de l'amplificateur A2 et l'entrée négative de A1. Le terme $(p1 + 2)$ Ve + $(p2 - 1)z^{-1}$ Ve peut se décomposer en deux éléments de circuits en parallèle, entre l'entrée du filtre (recevant Ve) et l'entrée négative de l'amplificateur A1, l'un de ces éléments étant du type de la figure 2c, avec une capacité C31 de valeur $p1 + 2$, et l'autre un élément du type de la figure 2a avec une capacité C'31 de valeur $p2 - 1$.

De la même manière, la deuxième équation permet de construire le schéma de connexions parvenant à l'entrée négative de l'amplificateur A2 : une capacité commutée C12 de valeur unitaire selon le schéma de la figure 2b relie la sortie de A1 à l'entrée de A2 pour établir le terme $z^-$V1. Une capacité de bouclage C22, non commutée, de valeur unitaire, est placée entre sortie et entrée de A2 pour établir le terme $(1 - z^{-1})$ V2, et une capacité non commutée C32 de valeur unitaire sera placée entre l'entrée du filtre et l'entrée négative de A2 pour établir le terme $(1 - z^{-1})$ Ve.

On aboutit ainsi directement au schéma de la figure 3. Il faut noter que certaines fonctions de transfert peuvent nécessiter des inverseurs pour établir certains coefficients négatifs.

Les filtres à capacités commutées selon l'invention peuvent être utilisés pour réaliser des démodulateurs de modems F.S.K. (frequency shift keying).

On rappelle qu'on désigne couramment sous le nom de modems, les modulateurs-démodulateurs qui comportent :

un modulateur, qui convertit une suite aléatoire de signaux binaires égaux à 0 ou à 1 en un signal analogique périodique, modulé en fréquence, en amplitude ou en phase, et transmissible par le réseau téléphonique ;

un démodulateur, qui convertit le signal analogique modulé fourni par le réseau en une suite de 0 ou de 1.

Dans les modems F.S.K., à un zéro, le modulateur fait correspondre une sinusoïde à une fréquence donnée $F_A$ et à un un, le modulateur fait correspondre une sinusoïde à une autre fréquence $F_z$.

La figure 4 représente le schéma d'un démodulateur de modem F.S.K. utilisant des filtres à capacités commutées selon l'invention.

Ce démodulateur comporte deux voies E et F sur lesquelles est simultanément envoyé le signal à démoduler qui est constitué de sinusoïdes à deux fréquences différentes $F_A$ et $F_z$.

Sur chaque voie se trouvent deux filtres à capacités commutées qui sont repérés par 5 et 6 sur la voie E et par 7 et 8 sur la voie F.

Le filtre 5 de la voie E a une fonction de transfert en $z^{-1}$ qui s'écrit $P(z^{-1})/Q(z^{-1})$. Le polynôme $P(z^{-1})$ s'annule à la fréquence $F_A$ par exemple et le polynôme $Q(z)$ s'annule à une fréquence imaginaire proche de la fréquence $F_z$, de façon que la fonction de transfert $P(z^{-1})/Q(z^{-1})$ présente une surtension à $F_z$. La fonction de transfert en $z^{-1}$, $P(z^{-1})/Q(z^{-1})$, du filtre 5 présente donc une paire de zéros conjugués dont un à $F_A$ et une paire de pôles conjugués dont un proche de $F_z$.

Le filtre 6 de la voie E a alors une fonction de transfert en $z^{-1}$ qui s'écrit

$$\frac{P(z^{-1})}{Q(z^{-1})} \cdot (1 - z^{-1}) \cdot K,$$

où K est une constante, et qui présente donc trois zéros dont deux conjugués et deux pôles conjugués.

Avec les filtres à capacités commutées selon l'invention, il est possible d'obtenir cette fonction de transfert en $z^{-1}$ dont le nombre de zéros est supérieur au nombre de pôles.

Les schémas électriques des filtres 5 et 6 peuvent être obtenus en utilisant, par exemple, une fonction de transfert $P(z^{-1})/Q(z^{-1})$ qui s'écrit :

$$\frac{P(z^{-1})}{Q(z^{-1})} = \frac{z^{-2} - 2\,z^{-1}.\cos\left(2\,\pi\,\dfrac{FA}{FH}\right) + 1}{z^{-2} - 2\,z^{-1}.\cos\left(2\,\pi\,\dfrac{FZ}{FH}\right) + 1},$$

où FH est la fréquence des signaux d'horloge $\Phi_1$ et $\Phi_2$.

Pour une fréquence différente de $F_A$, les tensions $V_1$ et $V_2$ en sortie des filtres 5 et 6 sont déphasées de $\Pi/2$. De plus, on choisit la constante K de la fonction de transfert du filtre 6 pour que les sorties des filtres 5 et 6 aient même amplitude à la fréquence $F_Z$.

Les filtres 7 et 8 de la voie F possèdent les mêmes caractéristiques que les filtres 5 et 6 de la voie E, il suffit de changer $F_A$ en $F_Z$ et $F_Z$ en $F_A$. Ainsi le filtre 7 a une fonction de transfert en z qui s'écrit : $R(z^{-1})/S(z^{-1})$ qui présente une paire de zéros conjugués dont un à $F_Z$ et une paire de pôles conjugués dont un proche de $F_A$, et le filtre 8 a une fonction de transfert en Z qui s'écrit :

$$\frac{R(z^{-1})}{S(z^{-1})} \cdot (1 - z^{-1}) \cdot K' ;$$

la constante K' étant déterminée pour que les deux filtres 7 et 8 aient même amplitude à la fréquence $F_A$.

Chacun des filtres 5, 6, 7 et 8 est suivi par un comparateur de tensions ayant une courbe de réponse représentée sur la figure 5 ; ce comparateur fournit un 1 logique, lorsque la tension d'entrée du comparateur est comprise entre $+ a - V_m$ et $- a - V_m$, où a est une constante inférieure à 0,7 et $V_m$ est l'amplitude maximale de la tension d'entrée du comparateur.

Les sorties des deux comparateurs de la voie, E, 15 et 16 sont reliées à un circuit logique « et » 25 et de même, les sorties des deux comparateurs de la voie F, 17 et 18, sont reliées à un circuit logique « et » 26.

Si on suppose que le signal envoyé à l'entrée du démodulateur est constitué par une sinusoïde à la fréquence $F_A$, les tensions $V_1$ et $V_2$ en sortie des filtres 5 et 6 de la voie E sont sensiblement nulles. En sortie des comparateurs 15 et 16, on obtient donc des 1 et donc un 1 également en sortie du « et » 25. Sur la voie F par contre, on obtient en sortie des filtres 7 et 8 deux tensions $V_3$ et $V_4$ déphasées entre elles de $\pi/2$. En sortie des comparateurs 17 et 18, on obtient donc à la fois un 1 et un 0, et donc on obtient aussi un 0 en sortie du « et » 26.

Si au contraire le signal à démoduler est à la fréquence $F_Z$, on obtient un 1 en sortie du « et » 26 et un 0 en sortie du « et » 25.

Ces résultats peuvent se résumer dans le tableau suivant :

|        | $F_A$ | $F_Z$ |
|--------|-------|-------|
| voie E | 1     | 0     |
| voie F | 0     | 1     |

## Revendications

1. Filtre actif à capacités commutées dont la fonction de transfert en z, T(z), s'écrit sous la forme

$$T(z) = z^{-k} \cdot \frac{P(z^{-1})}{Q(z^{-1})}$$

où $P(z^{-1})$ et $Q(z^{-1})$, sont deux polynômes en $z^{-1}$ de degrés m et n qui s'écrivent :

$$P(z^{-1}) = p_0 + p_1 z^{-1} + \cdots + p_m z^{-m}$$

$$Q(z^{-1}) = q_0 + q_1 z^{-1} + \cdots + q_n z^{-n},$$

avec $p0 \neq 0$, $q0 \neq 0$ et $k \geq 0$, caractérisé en ce que m est strictement supérieur à n, et en ce que la structure de ce filtre est obtenue de la façon suivante :
on écrit l'égalité entre la fonction de transfert T(z) et le rapport des déterminants de deux matrices carrées, A et B, de p lignes et p colonnes, où p représente la valeur supérieure de m et de n, chacun des

8

termes de ces matrices étant un polynôme du $1^{er}$ degré en $z^{-1}$ de la forme $a_{ij} \cdot z^{-1} + b_{ij}$, et les deux matrices ne différant que par les termes de leur dernière colonne :

$$T(z) = \frac{P(z^{-1})}{Q(z^{-1})} = \frac{\text{dét A}}{\text{dét B}} \; ;$$

on détermine à partir de cette égalité les coefficients $a_{ij}$ et $b_{ij}$ de façon que les polynômes $a_{ij} \cdot z^{-1} + b_{ij}$ puissent être obtenus par la mise en parallèle de dispositifs à capacités commutées classiques et de capacités :

on écrit les p équations découlant de la relation suivante :

$$\text{matrice B.} \begin{vmatrix} V_1 \\ V_2 \\ \cdot \\ \cdot \\ \cdot \\ V_p \end{vmatrix} - \begin{vmatrix} a_{1p}.z^{-1} + b_{1p} \\ a_{2p}.z^{-1} + b_{2p} \\ \cdot \qquad \cdot \\ \cdot \qquad \cdot \\ \cdot \qquad \cdot \\ a_{pp}.z^{-1} + b_{pp} \end{vmatrix} \cdot V_e = 0$$

où $V_e$ représente la tension d'entrée du filtre, où $V_1$, $V_2$ ... $V_p$ représentent les tensions de sortie des p amplificateurs différentiels que comporte le filtre, et où les polynômes affectant $V_e$ proviennent de la dernière colonne de la matrice A ;

on établit le schéma électrique du filtre à partir de ces équations, chaque équation correspondant à un amplificateur différentiel (1, 2, 3, 4) ayant son entrée positive à la masse et qui fournit une tension de sortie $V_i$, le coefficient affectant dans cette équation $V_e$ correspondant à des dispositifs à capacités commutées classiques en parallèle avec des capacités (10, 20, 30, 40) qui réalisent ce coefficient et qui sont intercalés entre l'entrée négative de l'amplificateur et la tension d'entrée $V_e$, les coefficients affectant les autres tensions $V_1$ ... $V_p$, exceptée $V_i$, correspondant à des dispositifs à capacités commutées classiques en parallèle avec des capacités (12, 13, 14, 22, 23 ...) qui réalisent ces coefficients et qui sont placés entre l'entrée négative de l'amplificateur fournissant $V_i$ et la sortie des amplificateurs fournissant les tensions $V_1$ ... $V_p$, exceptée $V_i$, enfin le coefficient affectant la tension $V_i$ correspondant à au moins une capacité (C) placée entre la sortie de l'amplificateur fournissant la tension de sortie $V_i$ et l'entrée négative de cet amplificateur, avec éventuellement en parallèle sur cette capacité des dispositifs à capacités commutées classiques et d'autres capacités (11, 22, 33, 44), la sortie du filtre étant prise à la sortie du $p^{ième}$ amplificateur et le retard éventuel $z^{-k}$ étant réalisé séparément.

2. Filtre selon la revendication 1, caractérisé en ce que les dispositifs à capacités commutées classiques utilisés comportent un dispositif constitué de deux interrupteurs ($I_1$, $I_2$) en série et d'une capacité (C) entre le point commun à ces interrupteurs et la masse, ces interrupteurs étant commandés par deux signaux d'horloge ($\Phi_1$, $\Phi_2$) en opposition de phase.

3. Filtres selon l'une des revendications 1 ou 2, caractérisé en ce que les dispositifs à capacités commutées classiques utilisés comportent un dispositif constitué de deux interrupteurs ($I_1$, $I_2$) en série entre l'entrée et la masse et de deux interrupteurs ($I_1$, $I_2$) en série entre la sortie et la masse, avec une capacité (C) qui relie les points communs aux deux séries d'interrupteurs, les interrupteurs en série étant commandés par des signaux d'horloge ($\Phi_1$, $\Phi_2$) en opposition de phase et les interrupteurs reliés à l'entrée et à la sortie étant également commandés par des signaux d'horloge ($\Phi_1$, $\Phi_2$) en opposition de phase.

4. Filtre selon l'une des revendications 1 à 3, caractérisé en ce que les dispositifs à capacités commutées classiques utilisés comportent un dispositif constitué de deux interrupteurs ($I_1$, $I_2$) en série entre l'entrée et la masse et de deux interrupteurs ($I_2$, $I_1$) en série entre la sortie et la masse, avec une capacité (C) qui relie les points communs aux deux séries d'interrupteurs, les interrupteurs en série étant commandés par des signaux d'horloge en opposition de phase ($\Phi_1$, $\Phi_2$) et les interrupteurs reliés à l'entrée et à la sortie recevant le même signal.

5. Filtre selon l'une des revendications 1 à 4, caractérisé en ce que les transformations suivantes sont effectuées sur les matrices A et B afin que les termes de ces matrices puissent être obtenus par des dispositifs à capacités commutées classiques en parallèle avec des capacités :

on remplace une ligne de la matrice A ou de la matrice B par une combinaison linéaire des lignes de la matrice considérée ;

on remplace une colonne de la matrice A ou de la matrice B par une combinaison linéaire des colonnes de la matrice considérée, exceptée la dernière colonne de la matrice A ;

on multiplie par une constante K une colonne des matrices A et B ;

on multiplie par une constante K une ligne des matrices A et B.

6. Filtre selon l'une des revendications 1 à 5, caractérisé par le fait qu'il comprend un nombre d'amplificateurs opérationnels égal à m + k.

7. Filtre selon l'une des revendications 1 à 6, caractérisé par le fait qu'il comprend des amplificateurs opérationnels parmi lesquels m amplificateurs sont connectés de la manière suivante : il est prévu entre la sortie de chacun des m amplificateurs opérationnels et l'entrée négative d'au moins un autre des m amplificateurs ou du même, un élément de circuit ou plusieurs éléments de circuits en parallèle, choisis chacun parmi les éléments de circuit représentés aux figures 2a, 2b, 2c et 2d.

8. Filtre selon la revendication 7, caractérisé par le fait que le filtre possède une entrée reliée à l'entrée négative d'au moins un autre des m amplificateurs par un élément de circuit ou plusieurs éléments de circuit en parallèle pris chacun parmi les éléments de circuit représentés aux figures 2a, 2b, 2c et 2d.

9. Filtre selon la revendication 8, caractérisé par le fait que la sortie de l'un des m amplificateurs présente par rapport à l'entrée du filtre la fonction de transfert $P(z^{-1})/Q(z^{-1})$.

10. Filtre selon l'une des revendications 7 à 9, caractérisé par le fait qu'il est prévu une capacité de liaison directe entre la sortie et l'entrée négative de chacun des m amplificateurs opérationnels.

11. Modem F.S.K., caractérisé en ce qu'il comporte un démodulateur qui comprend deux voies (E, F), chaque voie comportant deux filtres à capacités commutées (5 et 6, 7 et 8) selon l'une des revendications précédentes, qui sont placés en parallèle, les sorties des filtres d'une même voie étant reliées à un couple de comparateurs (15 et 16, 17 et 18), dont les sorties sont reliées à un circuit « et » (25, 26), l'un des filtres (5) de l'une des voies (E) ayant une fonction de transfert en z, $P(z^{-1})/Q(z^{-1})$ qui présente un zéro à une première fréquence ($F_A$) du modem et un pôle à une fréquence imaginaire proche de la deuxième fréquence ($F_Z$) du modem, l'autre filtre (6) de la même voie (E) ayant une fonction de transfert en z de la forme

$$\frac{P(z^{-1})}{Q(z^{-1})} \cdot (1 - z^{-1}) \cdot K,$$

où K est une constante choisie pour que les sorties des deux filtres aient même amplitude à la deuxième fréquence ($F_Z$) du modem, les filtres à capacités commutées (7 et 8) de l'autre voie (F) du modem ayant des fonctions de transfert en z,

$$R(z^{-1})/ S(z^{-1}) \quad \text{et} \quad \frac{R(z^{-1})}{S(z^{-1})} \cdot (1 - z^{-1}) \cdot K',$$

qui présentent un zéro à la deuxième fréquence ($F_Z$) du modem, un pôle à une fréquence imaginaire proche de la première fréquence ($F_A$) du modem et qui ont des sorties de même amplitude pour cette première fréquence.

12. Modem F.S.K., selon la revendication 11, caractérisé en ce que les fonctions de transfert en z des filtres du démodulateur s'écrivent :

$$\left( z^{-2} - 2\,z^{-1} \cdot \cos\left( 2\,\pi \frac{FA}{FH} \right) + 1 \right) \Big/ \left( z^{-2} - 2\,z^{-1} \cdot \cos\left( 2\,\pi \frac{FZ}{FH} \right) + 1 \right)$$

et

$$\left( z^{-2} - 2\,z^{-1} \cdot \cos\left( 2\,\pi \frac{FA}{FH} \right) + 1 \right) \cdot (1 - z^{-1}) \cdot K \Big/ \left( z^{-2} - 2\,z^{-1} \cdot \cos\left( 2\,\pi \frac{FZ}{FH} \right) + 1 \right)$$

pour les filtres (5 et 6) d'une voie (E), et

$$\left( z^{-2} - 2\,z^{-1} \cdot \cos\left( 2\,\pi \frac{FZ}{FH} \right) + 1 \right) \Big/ \left( z^{-2} - 2\,z^{-1} \cdot \cos\left( 2\,\pi \frac{FZ}{FH} \right) + 1 \right)$$

et

$$\left( z^{-2} - 2\,z^{-1} \cdot \cos\left( 2\,\pi \frac{FZ}{FH} \right) + 1 \right) \cdot (1 - z^{-1}) \cdot K' \Big/ \left( z^{-2} - 2\,z^{-1} \cdot \cos\left( 2\,\pi \frac{FZ}{FH} \right) + 1 \right)$$

pour les filtres (7 et 8) de l'autre voie (E), où FA et FZ sont les deux fréquences du modem et où $F_H$ est la fréquence des signaux d'horloge ($\Phi_1$, $\Phi_2$) des dispositifs à capacités commutées classiques utilisés dans les filtres du modem.

## Claims

1. Switched capacities active filter the transfer function of z, T(z), is of the form

$$T(z) = z^{-k} \cdot \frac{P(z^{-1})}{Q(z^{-1})},$$

wherein $P(z^{-1})$ and $Q(z^{-1})$ are two polynominals of $z^{-1}$ of the degrees m and n and of the form :

$$P(z^{-1}) = p_0 + p_1 z^{-1} + \cdots + p_m z^{-m}$$

$$Q(z^{-1}) = q_0 + q_1 z^{-1} + \cdots + q_n z^{-n}$$

with $p0 \neq 0$, $q0 \neq 0$ and $k \geqslant 0$, characterized in that m is strictly greater than n, and in that the structure of this filter is obtained in the following manner :

equality is established between the transfer function T(z) and the ratio of the determinants of two square matrices A and B of p lines and p columns, wherein p represents the greatest value of m and of n, each of the terms of these matrices being a polynominal of $z^{-1}$ of the first order and of the form $a_{ij} \cdot z^{-1} + b_{ij}$, and the two matrices differing only in the terms of their last column :

$$T(z) = \frac{P(z^{-1})}{Q(z^{-1})} = \frac{\text{Det A}}{\text{Det B}} \; ;$$

from this equality the coefficients $a_{ij}$ and $b_{ij}$ are determined so that the polynominals $a_{ij} \cdot z^{-1} + b_{ij}$ can be obtained by the parallel connection of conventional switched capacities devices and of capacities ;

the p equations resulting from the following relation are provided :

$$\text{Matrix B} \begin{vmatrix} V_1 \\ V_2 \\ \cdot \\ \cdot \\ \cdot \\ V_p \end{vmatrix} - \begin{vmatrix} a_{1p}.z^{-1} + b_{1p} \\ a_{2p}.z^{-1} + b_{2p} \\ \cdot \quad\quad\quad \cdot \\ \cdot \quad\quad\quad \cdot \\ \cdot \quad\quad\quad \cdot \\ a_{pp}.z^{-1} + b_{pp} \end{vmatrix} \cdot V_e = 0$$

wherein $V_e$ represents the input voltage of the filter, wherein $V_1$, $V_2$ ... $V_p$ represent the output voltages of the p differential amplifiers the filter comprises and wherein the polynominals associated with $V_e$ originate from the last column of the matrix A ;

the electrical diagram of the filter is established from these equations, each equation corresponding to a differential amplifier (1, 2, 3, 4) having its positive input connected to ground and supplying an output voltage $V_i$ the coefficient associated with $-V_e$ within this equation corresponding to conventional switched capacity devices connected in parallel to capacities (10, 20, 30, 40) embodying these coefficients and which are inserted between the negative input of the amplifier and the input voltage $V_e$, the coefficients associated with the other voltages $V_1$ ... $V_p$, except for $V_e$, corresponding to conventional switched capacities devices connected in parallel to capacities (12, 13, 14, 22, 23 ...) embodying these coefficients and which are placed between the negative input of the amplifier supplying $V_i$ and the output of the amplifiers supplying the voltages $V_1$ ... $V_p$, except for $V_i$, and the coefficient associated with the voltage $V_i$ corresponding to at least one capacity (C) placed between the output of the amplifier supplying the output voltage $V_i$ and the negative input of this amplifier, conventional switched capacities devices and further capacities (11, 22, 33, 44) being eventually provided in parallel to this capacity, the output of the filter being derived from the output of the $p^{th}$ amplifier and the eventual delay $z^{-k}$ being obtained separately.

2. Filter according to claim 1, characterized in that the conventional switched capacities devices which are used comprise a device formed of two interrupters ($I_1$, $I_2$) connected in series and of a capacity (C) between the common point of these interrupters and ground, these interrupters being controlled by two clock signals ($\Phi_1$, $\Phi_2$) of opposite phases.

3. Filter according to any of claims 1 and 2, characterized in that the conventional switched capacities devices which are used comprise a device formed of two interrupters ($I_1$, $I_2$) connected in series between the input and ground and of two interrupters ($I_1$, $I_2$) connected in series between the output and ground, with a capacity (C) connecting the common points of the two series connected interrupters, the series connected interrupters being controlled by clock signals ($\Phi_1$, $\Phi_2$) of opposite phases, and the interrupters connected ot the input and to the output being also controlled by clock signals ($\Phi_1$, $\Phi_2$) of opposite phases.

4. Filter according to any of claims 1 to 3, characterized in that the conventional switched capacities devices which are used comprise a device formed of two interrupters ($I_1$, $I_2$) connected in series between the input and ground and of two interrupters ($I_2$, $I_1$) connected in series between the output and ground, with a capacity (C) connecting the common points of the two series connected interrupters, the series connected interrupters being controlled by clock signals ($\Phi_1$, $\Phi_2$) of opposite phases and the interrupters connected to the input and to the output receiving the same signal.

5. Filter according to any of claims 1 to 4, characterized in that the following transformations are performed with the matrices A and B so that the terms of these matrices can be obtained by conventional switched capacity devices connected in parallel to capacities :

one line of the matrix A or of the matrix B is replaced with a linear combination of lines of the matrix considered ;

one column of the matrix A or of the matrix B is replaced with a linear combination of the columns of the matrix considered, except for the last column of the matrix A ;

one column of the matrices A and B is multiplied by a constant K ;

one line of the matrices A and B is multiplied by a constant K.

6. Filter according to any of claims 1 to 5, characterized by the fact that it comprises a number of operational amplifiers equal to m + k.

7. Filter according to any of claims 1 to 6, characterized by the fact that it comprises operational amplifiers among which m amplifiers are connected in the following manner : between the output of each of the m operational amplifiers and the negative input of at least another of the m amplifiers or of the same amplifier a circuit element or a plurality of parallel connected circuit elements are provided which are selected among the circuit elements represented in the Figures 2a, 2b, 2c and 2d.

8. Filter according to claim 7, characterized by the fact that the filter has an input connected to the negative input of at least another of the m amplifiers through a circuit element or a plurality of parallel connected circuit elements each taken among the circuit elements represented in Figures 2a, 2b, 2c and 2d.

9. Filter according to claim 8, characterized by the fact that the output of one of the m amplifiers presents, in relation to the input of the filter, the transfer function $P(z^{-1})/Q(z^{-1})$.

10. Filter according to any of claims 7 to 9, characterized by the fact that a direct connection capacity is provided between the output and the negative input of each of the m operational amplifiers.

11. F.S.K. modem, characterized in that it comprises a demodulator which comprises two channels (E, F), each channel comprising two switched capacity filters (5 and 6, 7 and 8) according to any of the preceding claims which are connected in parallel, the outputs of the filters of the same channel being connected to a comparator pair (15 and 16, 17 and 18) the outputs of which are connected to an AND circuit (25, 26), one of the filters (5) of one of the channels (E) having a transfer function of z, $P(z^{-1})/Q(z^{-1})$, presenting a zero at a first frequency $(F_A)$ of the modem and a pole at an imaginary frequency close to the second frequency $(F_Z)$ of the modem, the other filter (6) of the same channel (E) having a transfer function of z of the form

$$\frac{P(z^{-1})}{Q(z^{-1})} \cdot (1 - z^{-1}) \cdot K,$$

wherein K is a constant selected in such a manner that the outputs of the two filters have the same amplitude at the second frequency $(F_Z)$ of the modem, the switched capacities filters (7 and 8) of the other channel (F) of the modem having transfer functions of z

$$R(z^{-1})/ S(z^{-1}) \quad \text{and} \quad \frac{R(z^{-1})}{S(z^{-1})} \cdot (1 - z^{-1}) \cdot K',$$

having a zero at the second frequency $(F_Z)$ of the modem, a pole at an imaginary frequency close to the first frequency $(F_A)$ of the modem, and having outputs of the same amplitude for this first frequency.

12. F.S.K. modem according to claim 11, characterized in that the transfer functions of z of the filters of the demodulator are the following :

$$\left(z^{-2} - 2z^{-1} \cdot \cos\left(2\pi\frac{FA}{FH}\right) + 1\right) \Big/ \left(z^{-2} - 2z^{-1} \cdot \cos\left(2\pi\frac{FZ}{FH}\right) + 1\right)$$

and

$$\left(z^{-2} - 2z^{-1} \cdot \cos\left(2\pi\frac{FA}{FH}\right) + 1\right) \cdot (1 - z^{-1}) \cdot K \Big/ \left(z^{-2} - 2z^{-1} \cdot \cos\left(2\pi\frac{FZ}{FH}\right) + 1\right)$$

for the filters (5 and 6) of one channel (E) and

$$\left(z^{-2} - 2z^{-1} \cdot \cos\left(2\pi\frac{FZ}{FH}\right) + 1\right) \Big/ \left(z^{-2} - 2z^{-1} \cdot \cos\left(2\pi\frac{FZ}{FH}\right) + 1\right)$$

and

$$\left(z^{-2} - 2z^{-1} \cdot \cos\left(2\pi\frac{FZ}{FH}\right) + 1\right) \cdot (1 - z^{-1}) \cdot K' \Big/ \left(z^{-2} - 2z^{-1} \cdot \cos\left(2\pi\frac{FZ}{FH}\right) + 1\right)$$

for the filters (7 and 8) of the other channel (E), wherein FA and FZ are the two frequencies of the modem and wherein $F_H$ is the frequency of the clock signals ($\Phi_1$, $\Phi_2$) of the conventional switched capacities devices used within the filters of the modem.

**Patentansprüche**

1. Aktives Filter mit geschalteten Kapazitäten, dessen von z abhängige Übertragungsfunktion T(z) in folgender Form angegeben wird :

$$T(z) = z^{-k} \cdot \frac{P(z^{-1})}{Q(z^{-1})},$$

worin $P(z^{-1})$ und $Q(z^{-1})$ zwei Polynome von $z^{-1}$ sind, deren Grad m bzw. n ist und die folgendermaßen geschrieben werden :

$$P(z^{-1}) = p_0 + p_1 z^{-1} + \cdots + p_m z^{-m}$$

$$Q(z^{-1}) = q_0 + q_1 z^{-1} + \cdots + q_n z^{-n},$$

mit p0 ≠ 0, q0 ≠ 0 und k ⩾ 0, dadurch gekennzeichnet, daß m streng größer als n ist und daß die Struktur dieses Filters in folgender Weise erhalten wird :

die Übertragungsfunktion T(z) und das Verhältnis der Determinanten von zwei quadratischen Matrizen A und B aus p Zeilen und p Spalten werden als Gleichung geschrieben, wobei p den oberen Wert von m und n darstellt und jeder Term dieser Matrizen ein Polynom ersten Grades von $z^{-1}$ und folgender Form ist : $a_{ij} \cdot z^{-1} + b_{ij}$, und wobei die zwei Matrizen sich nur durch die Terme ihrer letzten Spalte unterscheiden :

$$F(z) = \frac{P(z^{-1})}{Q(z^{-1})} = \frac{\text{Det A}}{\text{Det B}};$$

aus dieser Gleichung werden die Koeffizienten $a_{ij}$ und $b_{ij}$ derart bestimmt, daß die Polynome $a_{ij} \cdot z^{-1} + b_{ij}$ durch Parallelschaltung von herkömmlichen Vorrichtungen mit geschalteten Kapazitäten und von Kapazitäten erhalten werden können :

es werden die p Gleichungen angegeben, die aus folgender Beziehung abgeleitet werden :

$$\text{Matrix B} \cdot \left( \begin{vmatrix} V_1 \\ V_2 \\ \cdot \\ \cdot \\ \cdot \\ V_p \end{vmatrix} - \begin{vmatrix} a_{1p}.z^{-1} + b_{1p} \\ a_{2p}.z^{-1} + b_{2p} \\ \cdot \\ \cdot \\ \cdot \\ a_{pp}.z^{-1} + b_{pp} \end{vmatrix} \right) \cdot V_e = 0$$

worin $V_e$ die Eingangsspannung des Filters und $V_1$, $V_2$ ... $V_p$ die Ausgangsspannungen der p Differenzverstärker darstellen, welche das Filter enthält, und worin die Polynome, mit denen $V_e$ behaftet ist, aus der letzten Spalte der Matrix A stammen ;

das elektrische Schaltbild des Filters wird aus diesen Gleichungen abgeleitet, wobei jede Gleichung einem Differenzverstärker (1, 2, 3, 4) entspricht, dessen positiver Eingang an Masse liegt und der eine Ausgangsspannung $V_i$ liefert, wobei der Koeffizient, mit dem in dieser Gleichung-$V_e$ behaftet ist, herkömmlichen Vorrichtungen mit geschalteten Kapazitäten in Parallelschaltung zu Kapazitäten (10, 20, 30, 40) entspricht, welche diese Koeffizienten verwirklichen und die zwischen den negativen Eingang des Verstärkers und die Eingangsspannung $V_e$ eingefügt sind, wobei die Koeffizienten, mit denen die anderen Spannungen $V_1$ ... $V_p$, mit Ausnahme von $V_e$, behaftet sind, herkömmlichen Vorrichtungen mit geschalteten Kapazitäten in Parallelschaltung zu Kapazitäten (12, 13, 14, 22, 23 ...) entsprechen, welche diese Koeffizienten verwirklichen und die zwischen den negativen Eingang des Verstärkers, welcher $V_e$ liefert, und den Ausbang der Verstärker geschaltet sind, welche die Spannungen $V_1$ ... $V_p$, mit Ausnahme von $V_i$ liefern, während schließlich der Koeffizient, mit dem die Spannung $V_i$ behaftet ist, wenigstens einer Kapazität (C) entspricht, die zwischen den Ausgang des die Ausgangsspannung $V_i$ liefernden Verstärkers und den negativen Eingang dieses Verstärkers geschaltet ist, gegebenenfalls unter Parallelschaltung von herkömmlichen Vorrichtungen mit geschalteten Kapazitäten und weiteren Kapazitäten (11, 22, 33, 44) zu dieser Kapazität, wobei der Ausgang des Filters vom Ausgang des $p^i$ ten Verstärkers abgeleitet ist und die eventuelle Verzögerung $z^{-k}$ getrennt verwirklicht wird.

2. Filter nach Anspruch 1, dadurch gekennzeichnet, daß die verwendeten herkömmlichen Vorrichtungen mit geschalteten Kapazitäten eine Vorrichtung enthalten, welche aus zwei Unterbrechern ($I_1$, $I_2$) in Reihenschaltung und aus einer Kapazität (C) zwischen dem Verbindungspunkt dieser Unterbrecher und Masse gebildet ist, wobei diese Unterbrecher durch zwei Taktsignale ($\Phi_1$, $\Phi_2$) gesteuert werden, die entgegengesetzte Phasenlage haben.

3. Filter nach Anspruch 1 oder 2, dadurch gekennzeichnet, daß die verwendeten herkömmlichen Vorrichtungen mit geschalteten Kapazitäten eine Vorrichtung enthalten, welche aus zwei in Reihe geschalteten Unterbrechern ($I_1$, $I_2$) zwischen dem Eingang und Masse und zwei in Reihe zwischen den Ausgang und Masse geschalteten Unterbrechern ($I_1$, $I_2$) gebildet ist, mit einer Kapazität (C), welche die Verbindungspunkte zwischen den zwei Reihenschaltungen von Unterbrechern verbindet, wobei die in Reihe geschalteten Unterbrecher durch Taktsignale ($\Phi_1$, $\Phi_2$) gesteuert werden, die entgegengesetzte Phasenlage aufweisen, und die mit dem Eingang und mit dem Ausgang verbundenen Unterbrecher ebenfalls durch Taktsignale ($\Phi_1$, $\Phi_2$) von entgegengesetzter Phasenlage gesteuert werden.

4. Filter nach einem der Ansprüche 1 bis 3, dadurch gekennzeichnet, daß die verwendeten herkömmlichen Vorrichtungen mit geschalteten Kapazitäten eine Vorrichtung enthalten, welche aus zwei Unterbrechern ($I_1$, $I_2$) in Reihenschaltung zwischen dem Eingang und Masse und zwei Unterbrechern ($I_2$, $I_1$) in Reihenschaltung zwischen dem Ausgang und Masse gebildet ist, mit einer Kapazität (C), welche die Verbindungspunkte zwischen den zwei Reihenschaltungen von Unterbrechern verbindet, wobei die in Reihe geschalteten Unterbrecher durch Taktsignale ($\Phi_1$, $\Phi_2$) von entgegengesetzter Phasenlage gesteuert werden und die mit dem Eingang und dem Ausgang verbundenen Unterbrecher dasselbe Signal empfangen.

5. Filter nach einem der Ansprüche 1 bis 4, dadurch gekennzeichnet, daß die folgenden Transformationen an den Matrizen A und B ausgeführt werden, damit die Terme dieser Matrizen durch herkömmliche Vorrichtungen mit geschalteten Kapazitäten in Parallelschaltung zu Kapazitäten erhalten werden können :

eine Zeile der Matrix A oder der Matrix B wird durch eine lineare Kombination von Zeilen der betrachteten Matrix ersetzt ;

eine Spalte der Matrix A oder der Matrix B wird durch eine lineare Kombination von Spalten der betrachteten Matrix ersetzt, ausgenommen die letzte Spalte der Matrix A ;

eine Spalte der Matrizen A und B wird mit einer Konstante K multipliziert ;

eine Zeile der Matrizen A und B wird mit einer Konstante K multipliziert.

6. Filter nach einem der Ansprüche 1 bis 5, dadurch gekennzeichnet, daß es eine Anzahl von Operationsverstärkern enthält, die gleich m + k ist.

7. Filter nach einem der Ansprüche 1 bis 6, dadurch gekennzeichnet, daß es Operationsverstärker enthält, von denen m Verstärker in folgender Weise geschaltet sind : Zwischen dem Ausgang jedes der m Operationsverstärker und dem negativen Eingang wenigstens eines weiteren der m Verstärker oder desselben Verstärkers ist ein Schaltungselement oder sind mehrere parallele Schaltungselemente vorgesehen, die jeweils unter den Schaltungselementen ausgewählt sind, welche in den Figuren 2a, 2b, 2c und 2d dargestellt sind.

8. Filter nach Anspruch 7, dadurch gekennzeichnet, daß das Filter einen Eingang aufweist, der mit dem negativen Eingang wenigstens eines weiteren der m Verstärker über ein Schaltungselement oder mehrere parallele Schaltungselemente verbunden ist, die jeweils unter den Schaltungselementen ausgewählt sind, welche in den Figuren 2a, 2b, 2c und 2d dargestellt sind.

9. Filter nach Anspruch 8, dadurch gekennzeichnet, daß der Ausgang eines der m Verstärker in bezug auf den Eingang des Filters die Übertragungsfunktion $P(z^{-1})/Q(z^{-1})$ aufweist.

10. Filter nach einem der Ansprüche 7 bis 9, dadurch gekennzeichnet, daß eine Kapazität zur direkten Verbindung zwischen dem Ausgang und dem negativen Eingang jedes der m Operationsverstärker vorgesehen ist.

11. FSK-Modem, dadurch gekennzeichnet, daß er einen Demodulator enthält, welcher zwei Kanäle (E, F) aufweist, wobei jeder Kanal zwei Filter mit geschalteten Kapazitäten (5 und 6, 7 und 8) nach einem der vorstehenden Ansprüche aufweist, die parallel geschaltet sind, wobei die Ausgänge der Filter desselben Kanals mit einem Vergleicherpaar (15 und 16, 17 und 18) verbunden sind, deren Ausgänge mit einer AND-Schaltung (25, 26) verbunden sind, wobei eines der Filter (5) eines der Kanäle (E) eine von z abhängige Übertragungsfunktion $P(z^{-1})/Q(z^{-1})$ aufweist, die eine Null bei einer ersten Frequenz ($F_a$) des Modems und einen Pol bei einer imaginären Frequenz aufweist, die nahe bei der zweiten Frequenz ($F_Z$) des Modems liegt, während das andere Filter (6) desselben Kanals (E) die von z abhängige Übertragungsfunktion folgender Form aufweist :

$$\frac{P(z^{-1})}{Q(z^{-1})} \cdot (1 - z^{-1}) \cdot K,$$

worin K eine Konstante ist, die so gewählt ist, daß an den Ausgängen der zwei Filter dieselbe Amplitude bei der zweiten Frequenz ($F_Z$) des Modems auftritt, wobei die Filter mit geschalteten Kapazitäten (7 und 8) des anderen Kanals (F) des Modems die von z abhängigen Übertragungsfunktionen

$$R(z^{-1}) / S(z^{-1}) \quad \text{und} \quad \frac{R(z^{-1})}{S(z^{-1})} \cdot (1 - z^{-1}) \cdot K'$$

aufweisen, die eine Null bei der zweiten Frequenz (F$_Z$) des Modems aufweisen und einen Pol bei einer imaginären Frequenz besitzen, die nahe bei der ersten Frequenz (F$_A$) des Modems liegt, und deren Ausgänge für diese erste Frequenz dieselbe Amplitude aufweisen.

12. FSK-Modem nach Anspruch 11, dadurch gekennzeichnet, daß die von z abhängigen Übertragungsfunktionen der Demodulatorfilter für die Filter (5 und 6) eines Kanales (E) folgendermaßen geschrieben werden :

$$\left( z^{-2} - 2\,z^{-1}.\cos\left(2\,\pi\frac{FA}{FH}\right) + 1 \right) \Bigg/ \left( z^{-2} - 2\,z^{-1}.\cos\left(2\,\pi\frac{FZ}{FH}\right) + 1 \right)$$

und

$$\left( z^{-2} - 2\,z^{-1}.\cos\left(2\,\pi\frac{FA}{FH}\right) + 1 \right).(1 - z^{-1}).K \Bigg/ \left( z^{-2} - 2\,z^{-1}.\cos\left(2\,\pi\frac{FZ}{FH}\right) + 1 \right)$$

und für die Filter (7 und 8) des anderen Kanals (E) folgende Form aufweisen :

$$\left( z^{-2} - 2\,z^{-1}.\cos\left(2\,\pi\frac{FZ}{FH}\right) + 1 \right) \Bigg/ \left( z^{-2} - 2\,z^{-1}.\cos\left(2\,\pi\frac{FZ}{FH}\right) + 1 \right)$$

und

$$\left( z^{-2} - 2\,z^{-1}.\cos\left(2\,\pi\frac{FZ}{FH}\right) + 1 \right).(1 - z^{-1}).K' \Bigg/ \left( z^{-2} - 2\,z^{-1}.\cos\left(2\,\pi\frac{FZ}{FH}\right) + 1 \right),$$

worin FA und FZ die zwei Frequenzen des Modems sind und worin F$_H$ die Frequenz der Taktsignale ($\Phi_1$, $\Phi_2$) der herkömmlichen Vorrichtungen mit geschalteten Kapazitäten ist, die in den Filtern des Modems verwendet werden.

# FIG_1

0 058 113

## FIG_2

(a)

(b)

(c)

(d)

## FIG_4

## FIG_5

# FIG_3